Europäisches Patentamt

European Patent Office

Office européen des brevets

(19)

(11) **EP 0 678 974 B1**

(12) **EUROPEAN PATENT SPECIFICATION**

(45) Date of publication and mention
of the grant of the patent:
**14.12.2005 Bulletin 2005/50**

(51) Int Cl.⁷: **H03D 7/16**, H04B 1/40

(21) Application number: **95302359.5**

(22) Date of filing: **10.04.1995**

(54) **A transmitter and/or receiver**

Sender und/oder Empfänger

Emetteur et/ou récepteur

(84) Designated Contracting States:
**DE FR GB SE**

(30) Priority: **21.04.1994 FI 941862**

(43) Date of publication of application:
**25.10.1995 Bulletin 1995/43**

(73) Proprietor: **Nokia Corporation**
**02150 Espoo (FI)**

(72) Inventor: **Väisänen, Risto**
**SF-24100 Salo (FI)**

(74) Representative: **Brax, Matti Juhani et al**
**Berggren Oy Ab,**
**P.O. Box 16**
**00101 Helsinki (FI)**

(56) References cited:
EP-A- 0 318 306          EP-A- 0 541 031
EP-A- 0 541 305          US-A- 4 246 539

• LIMANN O.; PELKA H.: "Fernsehtechnik ohne
Ballast" 1983, FRANZIS , MUNICH
• LIMANN O.; PELKA H.: "Funktechnik ohne
Ballast" 1984, FRANZIS , MUNICH

EP 0 678 974 B1

**EP 0 678 974 B1**

**Description**

The present invention relates to a method and a radio frequency system for generating the frequencies for a receiver and a transmitter in a radio communication system operating on two different frequency ranges, and to a receiver and a transmitter operating on two different frequency ranges, whereby a first frequency synthesizer generates a first mixer frequency and a second frequency synthesizer generates a second mixer frequency, the reception frequency is first mixed in the first mixer to a first intermediate frequency by the first mixer frequency, and the first intermediate frequency is further mixed to a second intermediate frequency in a second mixer by the second mixer frequency, and whereby the transmission frequency of the transmitter is generated by mixing the transmitted signal in a third mixer up to the transmission frequency by the first and second mixer frequencies. The invention also relates to the use of the methods and the radio frequency systems in a mobile phone.

It is well known to use a basic oscillator and one or more frequency synthesizers to generate stable local oscillator frequencies for the modulator of a transmitter and for the demodulator of a receiver. For receiving purposes a mixer frequency is generated, with the aid of which the transmitter's intermediate frequency signal is raised to the transmission frequency. In systems where the difference between the intermediate frequencies used in receiving and transmitting equals the duplex interval it is possible to use the same mixer frequency in the receiver and in the transmitter, and thus in these systems only one synthesizer is required to generate the mixer frequencies. Here the mixer frequency generally means the signal supplied to the local oscillator port of a mixer, modulator or demodulator. In systems where the difference between the intermediate frequencies used in receiving and transmitting differs from the duplex interval it is necessary to use at least two synthesizers in order to generate the mixer frequencies for the receiver and the transmitter.

Different systems use different frequency ranges and thus there must be separate synthesizers supplying different frequencies for systems operating at these different frequencies. Thus it is necessary to design and manufacture different circuits in order to generate the required frequencies in mobile phones of different systems. For instance manufacturers of GSM (Groupe Special Mobile) mobile phone systems and PCN mobile phone systems have to manufacture different RF parts for the GSM and the PCN telephones, even when the systems are generally similar digital cellular radio systems, except that the GSM operates on the 900 Mhz frequency range and the PCN on the 1800 Mhz frequency range.

The patent application FI-915220 (the corresponding European application was published as no. 541 305) presents an RF system solution which is easily changed to either of two different frequency ranges, whereby in a radiotelephone of a first radiotelephone system the mixer frequencies are generated so that they are equal to those of a radiotelephone of a second radiotelephone system operating on different transmit and reception frequency ranges, whereby a radiotelephone of the first radiotelephone system takes from the mixing results of the mixers a result which is different from that in a radiotelephone of a second radiotelephone system operating on different transmit and reception frequency ranges. Then the same frequency synthesizers can be used in radiotelephones operating on two different frequency ranges. Further prior art devices include EP-A-0 318 306, US-A-4 246 539 and EP-A-0 541 031.

However, the selection of mixing frequencies so that the same mixing frequencies can be used in a system operating at two different frequencies has in practice resulted in a situation where the synthesizer solution presented in the above mentioned patent application had to be made very complicated, whereby e.g. in the control loop of the synthesizer with the higher frequency it was necessary to use a mixer in order to avoid problems when generating the mixing frequencies. Even if it presents a method which with partly common RF parts can generate the frequencies for two radiotelephones operating on different frequency ranges, with this solution it is, however, very inconvenient to realize a combined telephone operating on two different frequency ranges, because it would require e.g. the use of different intermediate frequency filters on different frequency ranges.

A prior art publication Otto Limann, Horst Pelka: "Femsehtechnik ohne Ballast"; Franzis, Munich, DE, ISBN 3-7723-5274-X, 1983; especially figs. 3.01, 3.35, 4.02 and 4.03 with associated description is known to disclose a receiver that operates in first and second frequency ranges, has first and second intermediate frequencies and uses the same first intermediate frequency for both the first and second frequency ranges.

A prior art publication Otto Limann, Horst Pelka: "Funktechnik ohne Ballast" ; Franzis, Munich, DE, ISBN 3-7723-5266-9, 1983; especially pages 554-556 is also known to disclose a receiver that operates in first and second frequency ranges, has first and second intermediate frequencies and uses the same first intermediate frequency for both the first and second frequency ranges.

The present invention provides a method and a radio frequency system, with which the frequencies required to transmit and receive in a radio communication system operating on two different frequency ranges can be generated with substantially common RF parts, whereby it is simple to realize a receiver, a transmitter and a transceiver and thus a mobile phone operating on two different frequency ranges. The invention can well be used in mobile phones of a mobile phone system utilizing two different frequency ranges, such as in the GSM and the PCN mobile phone systems, as well as in a mobile phone operating on two different frequency ranges. This is realized by using the same intermediate frequencies on both frequency ranges, but a different frequency as the first mixing frequency on each frequency range, in that the frequency is suitably selected for each frequency range so that the received frequency of both different frequency ranges can be mixed down to the same first intermediate frequency.

A method according to the invention for generating the frequencies required in the receiver of a radio communication system operating on two different frequency ranges is characterized by the characterizing clause of claim 14.

A transceiver according to the invention operating on two different frequency ranges is characterized by the characterizing clause of the enclosed claim 1.

The methods and RF systems according to the invention can be used in a mobile phone of a mobile phone system operating on two different frequency ranges, and in a mobile phone operating on two different frequency ranges. The methods and the RF systems according to the invention required to generate the frequencies can as well be used in a paging device of a paging system operating on two frequency ranges, and thus the invention is not restricted only to radiotelephones.

The methods and the RF system for a transmitter and a receiver will be described in more detail below by describing a mobile phone according to the invention utilizing methods according to the invention to generate the frequencies of the transmitter and the receiver and an RF system according to the invention in the transmitter and the receiver. The invention is described with reference to the enclosed figures, in which:

figure 1 shows a block diagram of mobile phone RF parts according to the invention which can be used in a mobile phone of a mobile phone system operating on two different frequency ranges; and

figure 2 shows a block diagram of the RF parts in a combined telephone according to the invention operating on two different frequency ranges.

In the description we refer to frequency values, which were selected as examples in order to generate frequencies used in the GSM and the PCN systems. The transmit and receive frequencies used in these systems are as follows, and in order to implement the invention we selected the following internal frequencies of the telephones:

| GSM | receive | 935.2 ... 959.8 | Mhz |
| | transmit | 890 ... 915 | Mhz |
| | mixer frequency LO1 | 1215.6 ... 1240.2 Mhz | (RX) |
| | | 1222.6 ... 1247.2 Mhz | (TX) |
| | mixer frequency L02 | 332.4 | Mhz |
| | frequency L03 | 26 Mhz | |
| mixer frequency L01 | 1524.8 ... 1599.4 | Mhz | (RX) |
| | 1544.0 ... 1618.6 | Mhz | (TX) |
| mixer frequency L02 | 332.4 | | Mhz |
| demodulator | local | | oscillator |
| frequency L03 | 26 Mhz | | |

Here we can see that the systems have different first mixer frequencies.

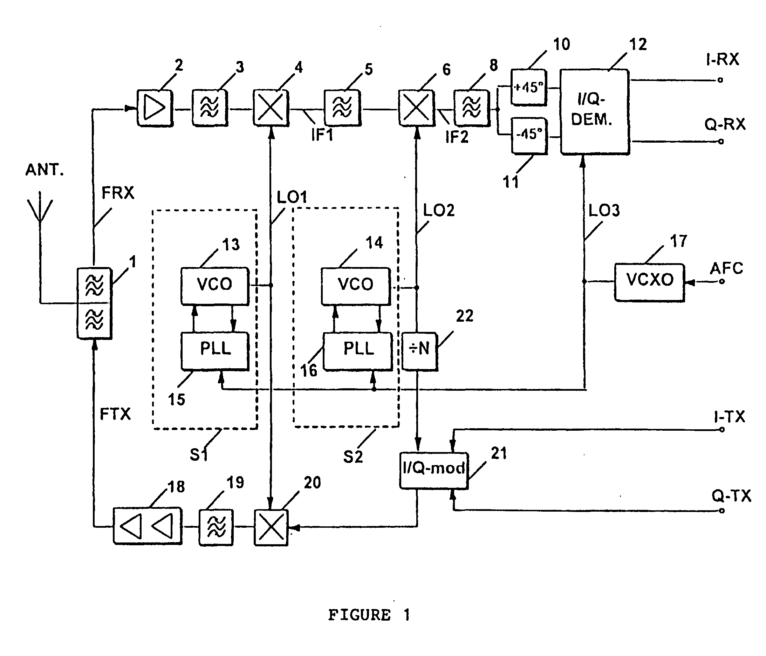

Figure 1 shows a block diagram of a mobile phone's RF parts in accordance with the invention which can be used in a mobile phone of a mobile phone system operating on two different frequency ranges. The blocks 2...12 represent a receiver, the blocks 13...16 represent a synthesizer, and the blocks 18...21 represent a transmitter. The figure shows two frequency synthesizers S1 and S2. The area S1 shown by broken lines represents the main synthesizer which is suitably selected to operate in the GSM system on the 1200 Mhz range and in the PCN system on the 1500 Mhz range. The synthesizer S2 operates in both systems at a frequency of about 300 Mhz. The first synthesizer S1 comprises a phase locked loop, in which as separate blocks are shown a voltage controlled oscillator 13 and a block 15 containing the phase locked loop filter, amplifier, frequency divider and a phase detector and operating on the variable frequency range LO1 (= first mixer frequency). The second synthesizer S2 comprises a phase locked loop, in which as separate blocks are shown a voltage controlled oscillator 14 and a block 16 containing the phase locked loop filter, amplifier, frequency divider and a phase detector and operating at a fixed frequency LO2 (= second mixer frequency). The design and realization of the phase locked loop is known per se by a person skilled in the art, and therefore it will not be described in further detail here. The reference frequency LO3 of the synthesizers S1 and S2 is generated by the 26 Mhz crystal oscillator 17, whose frequency is also supplied to the demodulator 12 as the third local oscillator signal of the receiver.

The received signal is supplied from the antenna ANT through the duplex filter 1 as the received frequency FRX to the preamplifier 2 and through the RF filter 3 to the mixer 3, where it is mixed with the first mixer frequency LO1 generated by the synthesizer S1 in order to provide the first intermediate frequency IF1. Both in the GSM and the PCN systems we use as the first intermediate frequency IF1 a synthesizer S1 in order to provide the first intermediate frequency IF1. Both in the GSM and the PCN systems we use as the first intermediate frequency IF1 a comparatively high frequency in order to avoid spurious response frequencies, which are due to the comparatively broad transmit and reception frequency range. The high first intermediate frequency is also advantageous in GSM, because then the required RF filters, such as ceramic filters, will be smaller and cheaper. From the mixer 4 the signal passes through the first intermediate frequency filter 5 to the second mixer 6, in which it is mixed with the mixer frequency LO2 supplied by the synthesizer S2 in order to provide the second intermediate frequency IF2. From the second mixer 6 the signal passes through the second intermediate frequency filter 8 and through the +45° and -45° phase shift blocks 10 and 11 to the demodulator 12, preferably an I/Q-demodulator, which also receives the local oscillator frequency L03.

In this embodiment in accordance with the invention the receiver I/Q-demodulator 12 operates in a slightly different way compared to a traditional I/Q-demodulator. Generally the intermediate frequency signal supplied to a demodulator is at the same frequency as the local oscillator signal. In the embodiment presented here for the GSM and PCN systems the local oscillator frequency LO3 is half of the intermediate frequency IF2. These frequencies can be processed with demodulators of a certain type, for instance with a demodulator of the type presented in patent application FI-915892.

Instead of the I/Q-demodulator 12 it is also possible to use an A/D-converter operating with a sub-sampling principle, and then the converter clock frequency is generated from the frequency LO3.

Correspondingly, in the transmitter the transmit signal I-TX, Q-TX supplied to the modulator is further supplied from the modulator 21, preferably an I/Q-modulator which in addition to the transmitted signal receives a frequency provided by the second mixer frequency LO2 divided by the divider 22, to the mixer 20, in which the signal is mixed up to the transmit frequency FTX by the first mixer frequency LO1. From the mixer 20 the signal is supplied through a transmit frequency RF filter 19 to the power amplifier 18, and from there the amplified signal is supplied through the duplex filter 1 to the antenna ANT.

In accordance with the invention the first and the second intermediate frequencies, respectively, are arranged to be equal in telephones using different transmit and reception frequency ranges, such as in telephones of the GSM and the PCN systems. Regarding the invention it does not make any difference whether the intermediate frequencies are generated from different mixing results in systems operating on different frequency ranges, if only the intermediate frequencies are of the same magnitude. The frequencies for each system may be selected. In an example in which for GSM LO1 is chosen to be larger than FRX and FTX and for PCN LO1 is smaller than FRX and FTX, the frequencies may be selected as follows:

| GSM: | 1st intermediate frequency | IF1 = LO1 - FRX = 280.4 Mhz |
| | 2nd intermediate frequency | IF2 = LO2 - IF1 = 52 Mhz |
| | transmit frequency | FTX = LO1 - LO2 |
| PCN: | 1st intermediate frequency | IF1 = FRX - LO1 = 280.4 Mhz |
| | 2nd intermediate frequency | IF2 = LO2 - ID1 = 52 Mhz |
| | transmit frequency | FTX = LO1 + (LO2)/2 |

The third local oscillator frequency LO3 is the same as the frequency generated by the crystal oscillator 17. A suitable crystal oscillator frequency for the GSM and the PCN systems is 26 Mhz, from which it is possible to form all clock frequencies required in the telephone. In order to minimize problems with spurious response and spurious radiation our calculations show that it is most preferable to use 280.4 Mhz as the first intermediate frequency. The intermediate frequency could be some other frequency, and besides the spurious problems it will not have any substantial effect on other factors than the frequency of the main synthesizer S1.

The signal supplied by the second synthesizer S2 as a carrier signal to the transmitter modulator 21 is divided by the divider 22 to form a suitable frequency. Here we use number 2 as divisor for the PCN system, and number 1 in the GSM system (i.e. no divisor is required in GSM). With the aid of the divisor the frequency range required from the main synthesizer S1 to provide the appropriate frequency LO1 for both GSM and PCN in each of transmit and receive modes and in particular to keep the variation in frequency of the LO1 between transmit and receive for the same system can be narrowed if necessary by changing the value of N. In the PCN system of this example, the frequency jump of the first synthesizer S1 between receive and transmit phases can be made shorter, as is shown below.

The difference between the transmit and receive ranges in the PCN system is 95 Mhz. Without the divider 22 the synthesizer's frequency change dLO1 between transmitting and receiving is:

| dLO1 = | IF1 -<br>= 280.4 Mhz-<br>= -147 Mhz | LO2<br>332.4 Mhz | - 95 Mhz<br>- 95 Mhz |
|---|---|---|---|

If the frequency LO2 supplied to the modulator is divided by two, then the synthesizer's frequency change is:

| dLO1 | = IF1 -<br>= 280.4 Mhz -<br>= 19.2 Mhz | (LO2)/2 -<br>166.2 Mhz - | 95 Mhz<br>95 Mhz |
|---|---|---|---|

In the GSM system the corresponding frequency change is:

$$dLO1 = IF2 - 45\ Mhz = 7\ Mhz$$

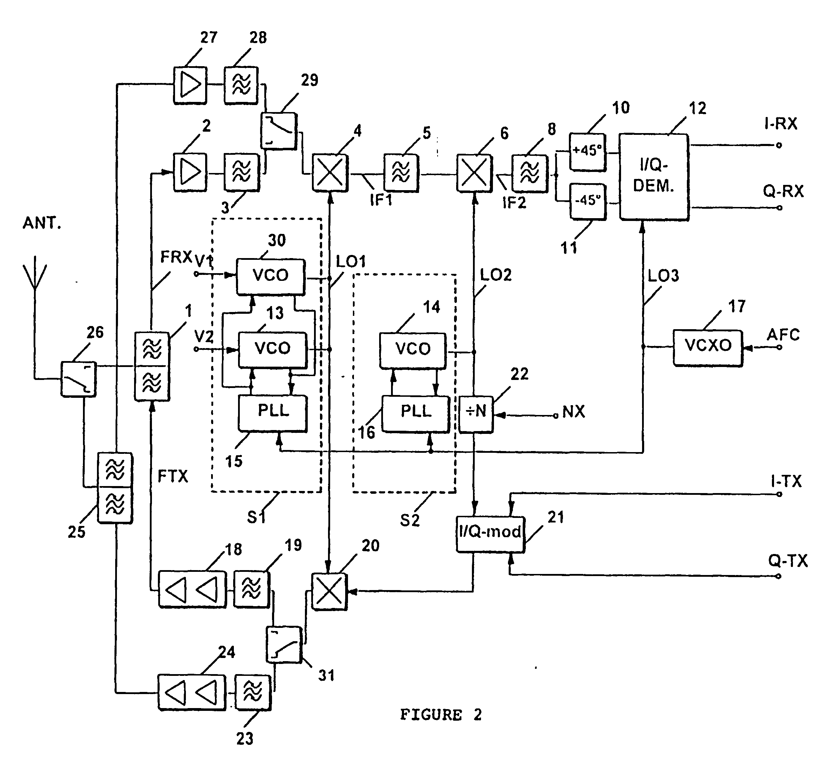

Figure 2 shows a block diagram of the RF parts in a combined telephone operating on two frequency ranges according to the invention.

In the receiver and transmitter there is for each frequency range a separate receiver front-end comprising a pre-amplifier 2, 27 and an RF filter 3, 28; and on the transmit side there are filters 19, 23 and a power amplifier 18, 25 for each frequency range.

In order to use the different parts when operating on different frequency ranges, change-over switches 26, 29, 31 are arranged in the antenna connection and in the transmitter mixer ports on the antenna side. When operating with two different frequency ranges the signal receiving side contains two duplex filters 1, 25; two preamplifiers 2, 27; and two receiver RF filters 3, 28. In a corresponding way the transmission side uses two transmitter RF filters 19, 23; two power amplifiers 18, 24; and two duplex filters 1, 25. The switches 26, 29, 31 select the respective one of the two similar blocks to be used. In order to generate the two different first mixer frequencies LO1 in accordance with the invention, two voltage controlled oscillators 13, 30 are arranged in the synthesizer S1, one of which is activated with the controls V1 and V2, depending on the frequency range with which the device operates, e.g. on the frequency range of the GSM or the PCN. The oscillator supply voltages can be used as controls V1 and V2 (i.e., the supply voltage is connected to only one of them). Each oscillator 13, 30 provides as output a different frequency. Instead of separate oscillators it would be possible to use two different frequency synthesizers S1 to generate the different mixing frequencies LO1, of which one is selected depending on the operating frequency range. Another alternative is to use one synthesizer S1 having two different frequency dividers in the phase locked loop 15, so that one of them is selected to be used. The divisor of the divider 22 is selected with the control NX. The divisor is 2 for the PCN system and 1 for the GSM system. At the frequencies shown here the antenna is a combination antenna for several frequency ranges. In other respects the RF parts are identical for both transmit and reception frequency ranges.

The RF change over switches 26, 29, 31 may be realized e.g. with PIN diodes or with GaAs FET transistors. Instead of switches 26, 29, 31 it is also possible to apply any known method to change the path of the RF signal.

With embodiments of the invention it is possible to realize a combined telephone for two different transmit and reception frequency ranges by using the same RF part for both frequency ranges, except for the parts in the transmitter output and in the receiver input and the synthesizer S1.

In order to generate the mixer frequencies LO1, LO2 according to the invention we can use synthesizer circuits S1 and S2 with such a low noise level that no mixing is required in the synthesizer. In a combined telephone operating on two different frequency ranges, e.g. in a combined telephone operating in the PCN and GSM systems, the intermediate frequency filters can be realized with SAW technology, so that a good short distance selectivity is obtained even at high frequencies with these filters.

Embodiments of the invention may be used in GSM and PCN mobile phones, but the invention is not restricted to the frequency ranges of these systems, but it may be applied e.g. in the DECT system and in paging systems. Methods and systems in accordance with the invention reduce the development costs and times for the RF parts, because the same RF parts can be used in two different systems. It will be more profitable to realize the RF parts as integrated circuits, because the same circuits can be used in several systems, and thus the manufacturing batch size will be larger and the unit price of the circuit will be lower, because the costs for development and manufacture of the integrated circuits will be lower. Moreover, the investment costs in the production will decrease as the same production line can be used for the manufacture of telephones of both systems (GSM, PCN), whereby only slight changes have to be made in the component insertion and testing programs.

In view of the foregoing description it will be evident to a person skilled in the art that various modifications may be made within the scope of the invention as defined by the appended claims.

**Claims**

1. A transceiver for operating in first and second respective frequency ranges comprising means (S1) for providing a first mixer signal (LO1) for use in a transmitting and receiving branch such that the first mixer signal (LO1) is mixed (4) with an incoming signal (FRX) to provide a first intermediate frequency signal (IF1) and the first intermediate frequency signal (IF1) is further mixed (6) to provide a second intermediate frequency signal (IF2), and a signal of a modulator output frequency is mixed (20) with the first mixer signal (LO1) to provide an outgoing signal (FTX), of which the frequency of the incoming signal (FRX) is arranged to be within a reception frequency band and the frequency of the outgoing signal (FTX) is arranged to be within a transmission frequency band when the transceiver operates within one of said first and second respective frequency ranges, and the first intermediate frequency (IF1) is substantially the same for each of the first and second respective frequency ranges,
   **characterised in that**

   - the modulator output frequency is substantially the same for each of the first and second respective frequency ranges,
   - the first mixer signal (LO1) has a first mixing frequency range to be used for operation in said first frequency range and a second mixing frequency range to be used for operation in said second frequency range,
   - said first mixing frequency range consists of a first reception subrange and a first transmission subrange, with a first frequency change between subranges,
   - said second mixing frequency range consists of a second reception subrange and a second transmission subrange, with a second frequency change between subranges, and
   - said second frequency change between subranges is different than said first frequency change between subranges.

2. A transceiver as claimed in Claim 1, wherein the means (S7) for providing the first mixer signal (LO1) comprises a frequency synthesizer.

3. A transceiver according to Claim 2, wherein the frequency synthesizer comprises first and second frequency oscillators (13, 30) for providing the first mixer signal in the first and second frequency ranges respectively.

4. A transceiver as claimed in Claim 1, comprising a second frequency synthesizer (S2) for providing a second mixer signal (L02).

5. A transceiver according to claim 4, wherein the second mixer signal (L02) is substantially the same for each of the first and second respective frequency ranges.

6. A transceiver according to Claim 4 or Claim 5, wherein in the receiving branch the second frequency synthesizer (S2) is coupled to a second mixer (6) providing the second intermediate frequency signal (IF2).

7. A transceiver according to Claim 6, wherein the second mixer signal (L02) is divided to provide a signal of suitable frequency to the second mixer.

8. A transceiver according to Claim 1, comprising a second frequency synthesizer (S2) for providing a second mixer signal (LO2), wherein in the transmitting branch the second frequency synthesizer (S2) is coupled to a modulator (21) for providing the signal of a modulator output frequency.

9. A transceiver according to Claim 8, wherein the second mixer signal (L02) is divided (22) to provide a signal of suitable frequency to the modulator (21).

10. A transceiver according to Claim 1 or any Claim appendant thereto, comprising a filter (5) in the receiving branch for passing the first intermediate frequency signal (IF1).

11. A transceiver according to Claim 1 or any Claim appendant thereto, comprising a filter (8) in the receiving branch for passing the second intermediate frequency signal (IF2).

**12.** A transceiver as claimed in any preceding Claim for use in a mobile phone operable for use in respective mobile phone systems transmitting and receiving in respective first and second frequency ranges.

**13.** A transceiver according to Claim 12, wherein the mobile phone systems are the Groupe Special Mobile (GSM) and Personal Communications Network (PCN).

**14.** A method for providing signals for a transceiver operable in first and second respective frequency ranges, comprising the steps of:

-   providing a first mixer signal (LO1) for use in a transmitting and receiving branch,
-   mixing (4) the first mixer signal (LO1) with an incoming signal (FRX) to provide a first intermediate frequency signal (IF1) and further mixing (6) the first intermediate frequency signal (IF1) to provide a second intermediate frequency signal (IF2),
-   mixing (20) a signal of a modulator output frequency with the first mixer signal (LO1) to provide an outgoing signal (FTX),

wherein the frequency of the incoming signal (FRX) is within a reception frequency band and the frequency of the outgoing signal (FTX) is within a transmission frequency band when the transceiver operates within one of said first and second respective frequency ranges, and the first intermediate frequency (IF1) is substantially the same for each of the first and second respective frequency ranges;
    **characterised in that**

-   the modulator output frequency is substantially the same for each of the first and second respective frequency ranges,
-   the first mixer signal (LO1) has a first mixing frequency range to be used for operation in said first frequency range and a second mixing frequency range to be used for operation in said second frequency range,
-   said first mixing frequency range consists of a first reception subrange and a first transmission subrange, with a first frequency change between subranges,
-   said second mixing frequency range consists of a second reception subrange and a second transmission subrange, with a second frequency change between subranges, and
-   said second frequency change between subranges is different than said first frequency change between subranges.

**Patentansprüche**

**1.** Sendeempfänger zum Betrieb in jeweiligen ersten und zweiten Frequenzbereichen, umfassend Mittel (S1) zum Bereitstellen eines ersten Mischsignals (LO1) zur Verwendung in einem Sende- und Empfangszweig, derart dass das erste Mischsignal (LO1) mit einem ankommenden Signal (FRX) gemischt wird (4), um ein erstes Zwischenfrequenzsignal (IF1) bereitzustellen, und das erste Zwischenfrequenzsignal (IF1) weiter gemischt wird (6), um ein zweites Zwischenfrequenzsignal (IF2) bereitzustellen, und ein Signal einer Modulatorausgangsfrequenz mit dem ersten Mischsignal (LO1) gemischt wird (20), um ein abgehendes Signal (FTX) bereitzustellen, wobei die Frequenz des ankommenden Signals (FRX) so ausgelegt ist, dass sie innerhalb eines Empfangsfrequenzbandes ist, und die Frequenz des abgehenden Signals (FTX) so ausgelegt ist, dass sie innerhalb eines Sendefrequenzbandes ist, wenn der Sendeempfänger innerhalb eines der jeweiligen ersten und zweiten Frequenzbereiche arbeitet, und die erste Zwischenfrequenz (IF1) für jeden der jeweiligen ersten und zweiten Frequenzbereiche im Wesentlichen dieselbe ist,
**dadurch gekennzeichnet, dass**

-   die Modulatorausgangsfrequenz für jeden der jeweiligen ersten und zweiten Frequenzbereiche im Wesentlichen dieselbe ist,

-   das erste Mischsignal (LO1) einen ersten Mischfrequenzbereich, der zum Betrieb im ersten Frequenzbereich zu verwenden ist, und einen zweiten Mischfrequenzbereich, der zum Betrieb im zweiten Frequenzbereich zu verwenden ist, aufweist,

-   wobei der erste Mischfrequenzbereich aus einem ersten Empfangsteilbereich und einem ersten Sendeteilbereich mit einer ersten Frequenzänderung zwischen Teilbereichen besteht,

- der zweite Mischfrequenzbereich aus einem zweiten Empfangsteilbereich und einem zweiten Sendeteilbereich mit einer zweiten Frequenzänderung zwischen Teilbereichen besteht, und

- die zweite Frequenzänderung zwischen Teilbereichen von der ersten Frequenzänderung zwischen Teilbereichen verschieden ist.

2. Sendeempfänger nach Anspruch 1, wobei das Mittel (S1) zum Bereitstellen des ersten Mischsignals (LO1) einen Frequenzsynthesizer umfasst.

3. Sendeempfänger nach Anspruch 2, wobei der Frequenzsynthesizer erste und zweite Oszillatoren (13, 30) zum Bereitstellen des ersten Mischsignals im ersten beziehungsweise zweiten Frequenzbereich umfasst.

4. Sendeempfänger nach Anspruch 1, welcher einen zweiten Frequenzsynthesizer (S2) zum Bereitstellen eines zweiten Mischsignals (L02) umfasst.

5. Sendeempfänger nach Anspruch 4, wobei das zweite Mischsignal (L02) für die jeweiligen ersten und zweiten Frequenzbereiche im Wesentlichen dasselbe ist.

6. Sendeempfänger nach Anspruch 4 oder 5, wobei im Empfangszweig der zweite Frequenzsynthesizer (S2) mit einem zweiten Mischer (6) verbunden ist, der das zweite Mischfrequenzsignal (IF2) bereitstellt.

7. Sendeempfänger nach Anspruch 6, wobei das zweite Mischsignal (L02) geteilt wird, um ein Signal einer geeigneten Frequenz an den zweiten Mischer zu liefern.

8. Sendeempfänger nach Anspruch 1, welcher einen zweiten Frequenzsynthesizer (S2) zum Bereitstellen eines zweiten Mischsignals (IF2) umfasst, wobei im Sendezweig der zweite Frequenzsynthesizer (S2) mit einem Modulator (21) zum Bereitstellen des Signals einer Modulatorausgangsfrequenz verbunden ist.

9. Sendeempfänger nach Anspruch 8, wobei das zweite Mischsignal (LO2) geteilt wird (22), um ein Signal einer geeigneten Frequenz an den Modulator (21) zu liefern.

10. Sendeempfänger nach Anspruch 1 oder einem dazugehörigen Anspruch davon, welcher ein Filter (5) im Empfangszweig zum Durchlassen des ersten Zwischenfrequenzsignals (IF1) umfasst.

11. Sendeempfänger nach Anspruch 1 oder einem dazugehörigen Anspruch davon, welcher ein Filter (8) im Empfangszweig zum Durchlassen des zweiten Zwischenfrequenzsignals (IF2) umfasst.

12. Sendeempfänger nach einem der vorhergehenden Ansprüche zur Verwendung in einem Mobiltelefon, das zur Verwendung in jeweiligen Mobiltelefonsystemen, die in jeweiligen ersten und zweiten Frequenzbereichen senden und empfangen, betriebsfähig ist.

13. Sendeempfänger nach Anspruch 12, wobei die Mobiltelefonsysteme das Groupe Special Mobile (GSM) und das Personal Communications Metwork (PCN) sind.

14. Verfahren zur Bereitstellung von Signalen für einen Sendeempfänger, der in jeweiligen ersten und zweiten Frequenzbereichen betrieben werden kann, umfassend die folgenden Schritte:

- Bereitstellen eines ersten Mischsignals (LO1) zur Verwendung in einem Sende- und Empfangszweig,

- Mischen (4) des ersten Mischsignals (LO1) mit einem ankommenden Signal (FRX), um ein erstes zwischenfrequenzsignal (IF1) bereitzustellen, und weiteres Mischen (6) des ersten Zwischenfrequenzsignals (IF1), um ein zweites Zwischenfrequenzsignal (IF2) bereitzustellen,

- Mischen (20) eines Signals einer Modulatorausgangsfrequenz mit dem ersten Mischsignal (LO1), um ein abgehendes Signal (FTX) bereitzustellen,

- wobei die Frequenz des ankommenden Signals (FRX) innerhalb eines Empfangsfrequenzbandes ist und die Frequenz des abgehenden Signals (FTX) innerhalb eines Sendefrequenzbandes ist, wenn der Sendeempfänger innerhalb eines der jeweiligen ersten und zweiten Frequenzbereiche arbeitet, und die erste Zwischenfrequenz (IF1) für jeden der jeweiligen ersten und zweiten Frequenzbereich im Wesentlichen dieselbe ist;

**dadurch gekennzeichnet, dass**

- die Modulatorausgangsfrequenz für jeden der jeweiligen ersten und zweiten Frequenzbereiche im Wesentlichen dieselbe ist,

- das erste Mischsignal (LO1) einen ersten Mischfrequenzbereich, der zum Betrieb im ersten Frequenzbereich zu verwenden ist, und einen zweiten Mischfrequenzbereich, der zum Betrieb im zweiten Frequenzbereich zu verwenden ist, aufweist,

- wobei der erste Mischfrequenzbereich aus einem ersten Empfangsteilbereich und einem ersten Sendeteilbereich mit einer ersten Frequenzänderung zwischen Teilbereichen besteht,

- der zweite Mischfrequenzbereich aus einem zweiten Empfangsteilbereich und einem zweiten Sendeteilbereich mit einer zweiten Frequenzänderung zwischen Teilbereichen besteht, und

- die zweite Frequenzänderung zwischen Teilbereichen von der ersten Frequenzänderung zwischen Teilbereichen verschieden ist.

**Revendications**

1.  Emetteur-récepteur destiné à fonctionner dans des première et seconde plages de fréquences respectives comprenant un moyen (S1) destiné à fournir un premier signal de mélangeur (LO1) pour une utilisation dans des branches d'émission et de réception, de sorte que le premier signal de mélangeur (LO1) soit mélangé (4) à un signal entrant (FRX) pour fournir un premier signal à fréquence intermédiaire (IF1) et le premier signal à fréquence intermédiaire (IF1) est ensuite mélangé (6) pour fournir un second signal à fréquence intermédiaire (IF2), et un signal à une fréquence de sortie d'un modulateur est mélangé (20) au premier signal de mélangeur (LO1) pour fournir un signal sortant (FTX), où la fréquence du signal entrant (FRX) est prévue être à l'intérieur d'une bande de fréquences de réception et la fréquence du signal sortant (FTX) est prévue être à l'intérieur d'une bande de fréquences d'émission, lorsque l'émetteur-récepteur fonctionne à l'intérieur de l'une desdites première et seconde plages de fréquences respectives, et la première fréquence intermédiaire (IF1) est sensiblement la même pour chacune des première et seconde plages de fréquences respectives,
    **caractérisé en ce que**

    - la fréquence de sortie du modulateur est sensiblement la même pour chacune des première et seconde plages de fréquences respectives,
    - le premier signal de mélangeur (LO1) a une première plage de fréquences de mélange à utiliser pour un fonctionnement dans ladite première plage de fréquences et une seconde plage de fréquences de mélange à utiliser pour un fonctionnement dans ladite seconde plage de fréquences,
    - ladite première plage de fréquences de mélange est constituée d'une première sous-plage de réception et d'une première sous-plage d'émission, une première différence de fréquence existant entre les sous-plages,
    - ladite seconde plage de fréquences de mélange est constituée d'une seconde sous-plage de réception et d'une seconde sous-plage d'émission, une seconde différence de fréquence existant entre les sous-plages, et
    - ladite seconde différence de fréquence entre les sous-plages est différente de ladite première différence de fréquence entre les sous-plages.

2.  Emetteur-récepteur selon la revendication 1, dans lequel le moyen (S7) destiné à fournir le premier signal de mélangeur (LO1) comprend un synthétiseur de fréquences.

3.  Emetteur-récepteur selon la revendication 2, dans lequel le synthétiseur de fréquences comprend des premier et second oscillateurs de fréquence (13, 30) destinés à fournir le premier signal de mélangeur dans les première et seconde plages de fréquences, respectivement.

4.  Emetteur-récepteur selon la revendication 1, comprenant un second synthétiseur de fréquences (S2) destiné à fournir un second signal de mélangeur (L02).

**5.** Emetteur-récepteur selon la revendication 4, dans lequel le second signal de mélangeur (LO2) est sensiblement le même pour chacune des première et seconde plages de fréquences respectives.

**6.** Emetteur-récepteur selon la revendication 4 ou la revendication 5, dans lequel, dans la branche de réception, le second synthétiseur de fréquences (S2) est relié à un second mélangeur (6) fournissant le second signal à fréquence intermédiaire (TF2).

**7.** Emetteur-récepteur selon la revendication 6, dans lequel le second signal de mélangeur (LO2) est divisé pour fournir un signal d'une fréquence appropriée au second mélangeur.

**8.** Emetteur-récepteur selon la revendication 1, comprenant un second synthétiseur de fréquences (S2) destiné à fournir un second signal de mélangeur (LO2), dans lequel, dans la branche d'émission, le second synthétiseur de fréquences (S2) est relié à un modulateur (21) destiné à fournir le signal à une fréquence de sortie du modulateur.

**9.** Emetteur-récepteur selon la revendication 8, dans lequel le second signal de mélangeur (LO2) est divisé (22) pour fournir un signal de fréquence appropriée au modulateur (21).

**10.** Emetteur-récepteur selon la revendication 1 ou selon l'une quelconque des revendications qui en dépendent, comprenant un filtre (5) dans la branche de réception, destiné à laisser passer le premier signal à fréquence intermédiaire (IF1).

**11.** Emetteur-récepteur selon la revendication 1 ou selon l'une quelconque des revendications qui en dépendent, comprenant un filtre (8) dans la branche de réception, destiné à laisser passer le second signal à fréquence intermédiaire (IF2).

**12.** Emetteur-récepteur selon l'une quelconque des revendications précédentes, destiné à une utilisation dans un téléphone mobile pouvant être mis en oeuvre pour une utilisation dans des systèmes de téléphonie mobile respectifs qui émettent et reçoivent dans des première et seconde plages de fréquences respectives.

**13.** Emetteur-récepteur selon la revendication 12, dans lequel les systèmes de téléphonie mobile sont le groupe spécial mobile (GSM) et le réseau de communications personnel (PCN).

**14.** Procédé destiné à fournir des signaux pour un émetteur-récepteur pouvant être mis en oeuvre dans des première et seconde plages de fréquences respectives, comprenant les étapes consistant à :

- fournir un premier signal de mélangeur (LO1) destiné à une utilisation dans une branche d'émission et une branche de réception,
- mélanger (4) le premier signal de mélangeur (LO1) à un signal entrant (FRX) pour fournir un premier signal à fréquence intermédiaire (IF1) et mélanger en outre (6) le premier signal à fréquence intermédiaire (IF1) pour fournir un second signal à fréquence intermédiaire (IF2),
- mélanger (20) un signal à une fréquence de sortie du modulateur au premier signal de mélangeur (LO1) pour fournir un signal sortant (FTX),

dans lequel la fréquence du signal entrant (FRX) se trouve à l'intérieur d'une bande de fréquences de réception et la fréquence du signal sortant (FTX) se trouve à l'intérieur d'une bande de fréquences d'émission lorsque l'émetteur-récepteur fonctionne à l'intérieur de l'une desdites première et seconde plages de fréquences respectives, et la première fréquence intermédiaire (IF1) est sensiblement la même pour chacune des première et seconde plages de fréquences respectives,
**caractérisé en ce que**

- la fréquence de sortie du modulateur est sensiblement la même pour chacune des première et seconde plages de fréquences respectives,
- le premier signal de mélangeur (LO1) a une première plage de fréquences de mélange à utiliser pour un fonctionnement dans ladite première plage de fréquences et une seconde plage de fréquences de mélange à utiliser pour un fonctionnement dans ladite seconde plage de fréquences,
- ladite première plage de fréquences de mélange est constituée d'une première sous-plage de réception et d'une première sous-plage d'émission, une première différence de fréquence existant entre les sous-plages,
- ladite seconde plage de fréquences de mélange est constituée d'une seconde sous-plage de réception et d'une seconde sous-plage d'émission, une seconde différence de fréquence existant entre les sous-plages, et

- ladite seconde différence de fréquence entre les sous-plages est différente de ladite première différence de fréquence entre les sous-plages.

FIGURE 1

FIGURE 2

EP 0 678 974 B1

13